# FASCICULE DE BREVET EUROPEEN

(11) **EP 1 640 335 B1**
(45) Date de publication et mention de la délivrance du brevet: **12.06.2013**
(21) Numéro de dépôt: 05354030.8
(22) Date de dépôt: 12.08.2005
(51) Int. Cl.: B81B 7/00, B81B 3/00

(54) **Composant d'encapsulation de micro-systèmes électromécaniques intégrés et procédé de réalisation du composant**
Bauelement zum Verkapseln von elektromechanischen integrierten Mikrosystemen und Herstellungsverfahren
Packaging device for electromechanical integrated microsystems and its method of fabrication

(30) Priorité: 28.09.2004 FR 0410232
(43) Date de publication de la demande: 29.03.2006
(73) Titulaire: Commissariat à l'Énergie Atomique et aux Énergies Alternatives, 75015 Paris (FR)
(72) Inventeur: Delapierre, Gilles, 38180 Seyssins (FR)
(74) Mandataire: Hecké, Gérard

(56) Documents cités:
- WO-A-01/58804
- WO-A-03/070625
- AIGNER R ET AL: ""Cavity-Micromachining" technology: zero-package solution for inertial sensors" TRANSDUCERS '01. EUROSENSORS XV. 11TH INTERNATIONAL CONFERENCE ON SOLID-STATE SENSORS AND ACTUATORS, 10-14 JUNE 2001. DIGEST OF TECHNICAL PAPERS SPRINGER-VERLAG, vol. 1, 2001, pages 186-189 vol.1, XP001205670 BERLIN, GERMANY ISBN: 3-540-42150-5
- STARK B H ET AL: "A LOW-TEMPERATURE THIN-FILM ELECTROPLATED METAL VACUUM PACKAGE" JOURNAL OF MICROELECTROMECHANICAL SYSTEMS, IEEE INC. NEW YORK, US, vol. 13, no. 2, avril 2004 (2004-04), pages 147-157, XP001200235 ISSN: 1057-7157
- JEN-YI CHEN ET AL: "A novel device-level micropackaging using micro assembly transfer" MICRO-ELECTRO-MECHANICAL SYSTEMS (MEMS). 2001 ASME INTERNATIONAL MECHANICAL ENGINEERING CONGRESS AND EXPOSITION, NOV. 11-16, 2001, pages 769-774, XP009046230 NEW YORK, NY, USA ISBN: 0-7918-3555-3
- CHANG-HYUN BAE ET AL: "Fabrication of cylinder type micro channel using photoresist reflow and isotropic etching" MICROPROCESSES AND NANOTECHNOLOGY CONFERENCE, 2003. DIGEST OF PAPERS. 2003 INTERNATIONAL OCT. 29-31, 2003, PISCATAWAY, NJ, USA,IEEE, 29 octobre 2003 (2003-10-29), pages 200-201, XP010684646 ISBN: 4-89114-040-2

## Description

### Domaine technique de l'invention

L'invention concerne un composant comportant des micro-systèmes électromécaniques intégrés dans une première cavité délimitée au moins par un substrat et par une paroi supérieure, constituée par au moins une partie d'un premier capot.

### État de la technique

La technologie des micro-systèmes électromécaniques intégrés (« MEMS : micro electro-mechanical systems ») a connu un développement considérable au cours des dernières années. Les applications les plus connues sont les accéléromètres pour airbag, les gyromètres pour navigation et les commutateurs radiofréquence et optiques pour les télécoms.

Afin de réduire les coûts de fabrication, on cherche à appliquer de façon toujours plus poussée le principe de fabrication collective, sur lequel repose toute la puissance des micro-technologies. Ainsi, on cherche à fabriquer des puces les plus petites possibles pour en avoir le plus grand nombre possible sur un même substrat.

La fabrication collective est d'autant plus intéressante si elle comporte toutes les étapes de la fabrication. Cependant, souvent certaines étapes de la fabrication sont effectuées collectivement, tandis que d'autres étapes sont effectuées individuellement sur chaque puce. L'étape de scellement par exemple est très coûteuse si elle est réalisée au niveau de la puce individuelle après découpe du substrat.

Un MEMS actuel est typiquement constitué d'un substrat et de micro-systèmes électromécaniques intégrés dans une cavité. Afin de protéger les micro-systèmes, un capot est fixé sur le substrat par des moyens de scellement destinés à rendre la cavité étanche.

On cherche à développer des procédés qui soient à la fois :
- collectifs sur tranche,
- peu consommateurs de surface de silicium (pour réduire la taille des puces),
- capables de garantir une très bonne herméticité de longue durée et dans des environnements sévères de température et d'humidité,
- peu générateurs de contraintes parasites,
- de préférence réalisables à basse température (< 450°C).
Les composants obtenus par ces procédés doivent être aptes à supporter les opérations ultérieures de mise en boîtier, notamment par enrobage en matière plastique ou surmoulage.

Aucune des techniques connues à ce jour ne permet de satisfaire en même temps à toutes ces conditions.

Une première technique connue consiste à sceller un capot par un cordon de matériau polymère. L'intérêt de cette solution est que la forme du cordon peut être définie par des techniques de photolithographie, qui permettent de réaliser des cordons de très petite largeur (quelques dizaines de micromètres), peu consommateurs de surface de puce. Le scellement peut de plus être effectué par des moyens simples à basse température. Les composants obtenus par cette technique supportent l'opération de surmoulage mais l'inconvénient majeur est qu'il est impossible de garantir, avec un polymère, une très bonne herméticité, notamment au vide. Les polymères résistent d'autre part mal aux agressions de l'environnement.

Une deuxième technique, très utilisée aujourd'hui, consiste à utiliser un cordon de verre fusible déposé par sérigraphie. On trouve des verres fusibles à 450°C et cette technique assure une bonne herméticité. Les composants obtenus par cette technique supportent l'opération de surmoulage. Elle présente, cependant, l'inconvénient important de conduire à des cordons de très grande largeur (quelques centaines de micromètres), ce qui devient inacceptable pour les produits de grande diffusion. Par exemple, la surface des puces pour capteur d'accélération de la prochaine génération sera de l'ordre du millimètre au carré. Or, la largeur du cordon est liée à la technique de dépôt de la pâte de verre par sérigraphie et il est donc difficile d'espérer réduire cette largeur.

Une troisième technique, plus intégrée, consiste à remplacer le capot par une couche mince déposée. Le déroulement typique d'un procédé de ce type comporte un dépôt d'une couche sacrificielle, le dépôt de la couche mince servant de capot et l'enlèvement de la couche sacrificielle. La couche capot est souvent en silicium polycristallin, matériau quelquefois utilisé également pour le MEMS lui-même. Le capot est ensuite recouvert d'un enrobage en matière plastique surmoulée. Cette technique présente l'intérêt d'une très grande miniaturisation et donc d'un coût potentiel très bas. Elle utilise un scellement minéral, donc hermétique. Un inconvénient important de cette technique est cependant que le capot ne peut tenir les pressions élevées de l'enrobage en matière plastique surmoulée, en particulier lorsque la surface du capot est grande.

Une solution pour remédier à ce problème consiste à faire reposer le capot sur un grand nombre de petits piliers qui limitent le fléchissement du capot en couche mince. Cependant, ceci encombre le dispositif et limite fortement la liberté de conception du MEMS, puisque pour tenir des pressions de l'ordre de 100 bars, les piliers doivent être très rapprochés, typiquement à quelques dizaines de microns. Même avec des espacements aussi faibles, les marges de sécurité par rapport à la limite de rupture du capot ou des piliers restent faibles. Ceci est aggravé par le fait que le plastique solide de surmoulage exerce des forces non seulement hydrostatiques, mais également de cisaillement sur le capot lorsqu'il se solidifie, à cause de la différence des coefficients de dilatation thermique. Une méthode connue pour améliorer la tenue au surmoulage est de poser sur la puce une goutte de gel visqueux qui absorbe les contraintes, notamment les contraintes de cisaillement lors de la solidification. Cette méthode n'est cependant pas collective et elle est mal adaptée à une mise en production en salle blanche. Par ailleurs, le surmoulage est souvent mis en oeuvre par une entreprise autre que celle qui fabrique la puce et le transport de la puce avec le gel déjà déposé pose, aussi, des problèmes de fiabilité et de détermination des responsabilités en cas de problèmes. Une autre solution peut être de déposer le gel chez le fabricant du surmoulage, mais ceci nécessiterait une adaptation spécifique de l'outil de production.

Le document WO01/58804 décrit la réalisation d'une seule cavité étanche comportant une couche de protection inférieure et une couche de protection supérieure. Les deux couches de protection sont scellées pour permettre l'étanchéité de la cavité. Le document WO 03/070625 décrit la réalisation d'une poutre mobile qui est recouverte par un matériau sacrificiel sur lequel est formé une couche d'encapsulation.

### Objet de l'invention

L'invention a pour but de remédier à ces inconvénients et, plus particulièrement, de proposer un procédé d'encapsulation collective de micro-systèmes électromécaniques intégrés minimisant les problèmes d'encombrement, de dilatation thermique, de solidité du capot et de coût de fabrication.

Selon l'invention, ce but est atteint par les revendications annexées et, plus particulièrement, par le fait que le composant comporte un second capot, constitué par une couche mince, délimitant une seconde cavité, au moins avec la totalité de la paroi supérieure de la première cavité.

L'invention a également pour but un procédé de fabrication d'un composant selon la revendication 1 annexée, le procédé comportant successivement, après la réalisation des micro-systèmes électromécaniques et du premier capot délimitant une première cavité étanche,
- le dépôt, sur la totalité de la paroi supérieure de la première cavité, d'une couche en matière polymère,
- le recuit de la couche en matière polymère,
- le dépôt, sur la couche en matière polymère, de la couche mince destinée à former le second capot,
- la gravure d'au moins un orifice dans le second capot,
- l'enlèvement de la couche en matière polymère par l'intermédiaire de l'orifice.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 représentent, en coupe, deux modes de réalisation particuliers d'un composant selon l'invention.
Les figures 3 à 5 illustrent, en coupe, un mode de réalisation particulier d'un procédé de fabrication selon l'invention.

### Description de modes particuliers de réalisation

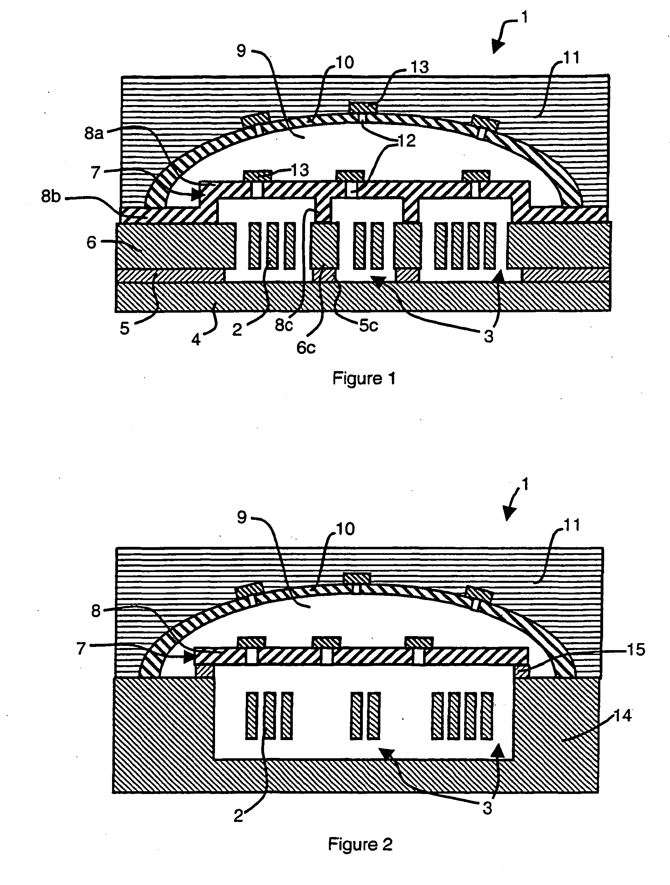

La figure 1 représente un composant 1 d'encapsulation de micro-systèmes électromécaniques 2 intégrés dans une première cavité 3. La première cavité 3 est étanche. Comme représenté à la figure 1, les micro-systèmes 2 peuvent être constitués d'éléments suspendus. Dans le mode de réalisation particulier représenté à la figure 1, la première cavité 3 est délimitée par un substrat de support 4, par les faces latérales d'une couche isolante 5, par un substrat 6 micro-structuré, dans lequel sont usinés les micro-systèmes 2, et par une paroi supérieure 7 de la première cavité 3, constituée par une partie surélevée 8a d'un premier capot 8. Des parties inférieures 8b du premier capot 8 disposées de part et d'autre de la partie surélevée 8a reposent sur le substrat 6 microstructuré. De plus, comme représenté à la figure 1, la partie surélevée 8a peut être posée sur des colonnes constituées chacune par la superposition d'une partie inférieure intermédiaire 8c du premier capot 8, d'une partie intermédiaire 6c du substrat 6 microstructuré et d'une partie intermédiaire 5c de la couche isolante 5.

Une seconde cavité 9 est délimitée par la totalité de la paroi supérieure 7 de la première cavité 3, par les parties inférieures 8b du premier capot 8 et par un second capot 10 constitué par une couche mince et, le cas échéant, par des bouchons 13 déposés sur le second capot 10 et gravés. La couche mince constituant le second capot 10 est, de préférence, bombée. Comme représenté à la figure 1, le second capot 10 peut être recouvert par un enrobage 11 en matière plastique surmoulée permettant de protéger le composant.

Sur la figure 1, les premier (8) et second (10) capots comportent des orifices 12, permettant d'enlever des couches sacrificielles utilisées pour la fabrication des capots, et des bouchons 13 refermant les orifices 12.

Sur la figure 2, la première cavité 3 est délimitée par un substrat 14, par un joint de scellement 15 et par la paroi supérieure 7 de la première cavité 3, constituée par la totalité d'un premier capot 8 plat. La seconde cavité 9 est délimitée par la totalité de la paroi supérieure 7 de la première cavité 3, par des faces latérales de la couche de scellement 15, par une face avant du substrat 14 et par le second capot 10.

Selon l'invention, la totalité de la paroi supérieure 7 de la première cavité 3 délimite la seconde cavité 9, c'est-à-dire le second capot 10 n'est pas en contact avec la paroi supérieure 7 de la première cavité 3. Le second capot 10 est apte à tenir des forces de cisaillement et des pressions fortes, par exemple les pressions de la matière plastique constituant l'enrobage 11 du composant 1.

Le second capot 10 est très solide lorsqu'il a une forme bombée. Le second capot 10 forme alors une coupole de protection disposée au-dessus du premier capot 8, sans venir en contact avec la paroi supérieure 7 de la cavité 3. En effet, par exemple sur la figure 1, le second capot 10 est posé sur les parties inférieures 8b du premier capot 8 disposées de part et d'autre de la partie surélevée 8a du premier capot 8. Dans le mode de réalisation particulier représenté à la figure 2, le second capot 10 est posé sur le substrat 14. Ainsi, dans les deux cas, aucune force de cisaillement n'est exercée sur la paroi supérieure 7 par l'enrobage 11.

La réalisation des micro-systèmes électromécaniques 2 et du premier capot 8 peut être effectuée de manière connue, par exemple comme décrit dans le document « Cavity-Micromachining Technology : Zero-Package Solution for Inertial Sensors » de R. Aigner et Al. (Transducers '01 Eurosensor XV, 11th International Conference on Solid-State Sensors and Actuators, Munich, Germany, June 10-14, 2001). Ainsi, une couche de silicium polycristallin ou monocristallin est réalisée, par un dépôt de type épitaxie ou par collage moléculaire, sur la couche isolante 5 qui est, par exemple, en silice. Ladite couche de silicium est gravée, par exemple par gravure ionique réactive anisotrope, pour obtenir le substrat 6 micro-structuré.

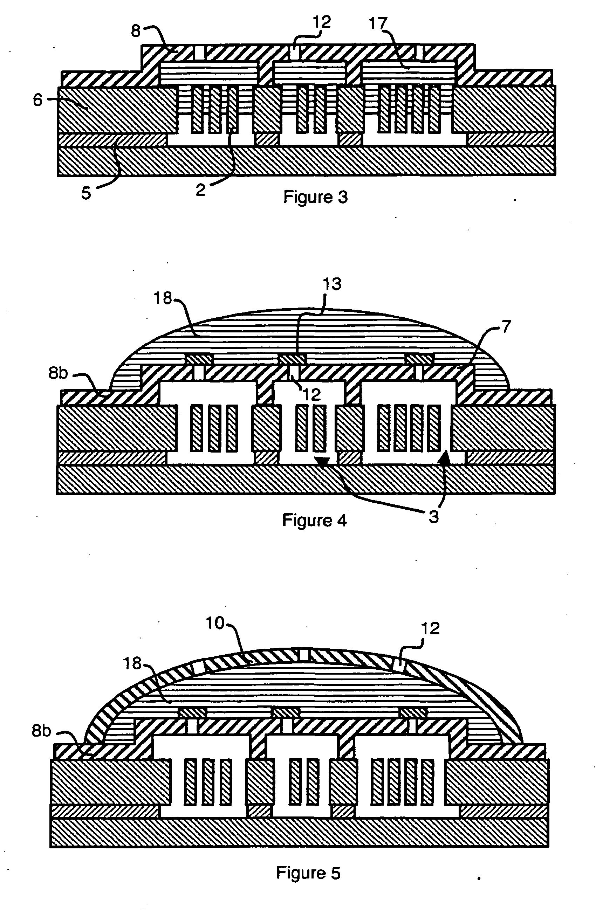

Ensuite, comme représenté à la figure 3, une première couche sacrificielle 17 est déposée sur les micro-systèmes électromécaniques 2 et sur le substrat 6 micro-structuré. La première couche sacrificielle 17 est, par exemple, constituée par une couche isolante réalisée par dépôt chimique en phase vapeur et gravée pour définir la forme du premier capot 8 et de la première cavité 3. L'épaisseur de la première couche sacrificielle 17 n'est, généralement, pas supérieure à quelques micromètres. En effet, d'une part, les techniques de dépôt classiquement utilisées ne permettent pas d'obtenir une épaisseur supérieure à quelques micromètres et, d'autre part, la durée de gravure pour l'enlèvement de la couche sacrificielle ne doit pas être trop importante. Ainsi, le premier capot 8 a automatiquement une forme plate, ce qui limite sa tenue à la pression.

Le premier capot 8 est ensuite réalisé par dépôt, sur la première couche sacrificielle 17 et sur le substrat 6, d'une couche mince, par exemple du silicium polycristallin. Puis, les orifices 12 sont gravés dans le premier capot 8 et la première couche sacrificielle 17 est enlevée, par exemple par attaque chimique utilisant un bain à base d'acide fluorhydrique, de manière à former la première cavité 3, comme représenté à la figure 4. Après enlèvement de la première couche sacrificielle 17, les orifices 12 du premier capot 8 sont obturés par l'intermédiaire de bouchons 13, réalisés par exemple par dépôt chimique en phase vapeur ou par sérigraphie de verre fusible.

Le second capot 10 est, de préférence, réalisé par une autre technique que celle utilisée pour le premier capot 8, afin d'obtenir une forme bombée du second capot 10, plus solide pour supporter des pressions élevées et des forces de cisaillement. Pour cela, une couche en matière polymère 18, constituant une seconde couche sacrificielle, est déposée sur la totalité de la paroi supérieure 7 de la première cavité 3 et sur les parties inférieures 8b du premier capot 8. La couche en matière polymère 18 est, par exemple, réalisée par un dépôt à la tournette et par une gravure permettant de délimiter latéralement la couche en matière polymère 18. La couche en matière polymère 18 est ensuite recuite, ce qui permet d'obtenir une surface bombée de la couche en matière polymère 18, notamment par fluage et par l'effet des tensions internes. Sur la figure 4, par exemple, la couche en matière polymère 18 est convexe, après le recuit.

Comme représenté à la figure 5, une couche mince, destinée à former le second capot 10, est déposée sur les parties inférieures 8b et sur la couche en matière polymère 18 et prend automatiquement une forme bombée. La couche mince bombée est, de préférence, obtenue par dépôt chimique en phase vapeur de nitrure de silicium ou d'un métal et gravée latéralement pour lui donner la forme du second capot 10. Comme représenté à la figure 5, des orifices 12 sont gravés dans le second capot 10. La seconde couche sacrificielle 18 est enlevée par l'intermédiaire des orifices 12, de manière à vider la seconde cavité 9, par exemple par une attaque par plasma d'oxygène (figure 1).

Ensuite, une couche d'obturation peut être déposée sur les emplacements des orifices 12 du second capot 10, de manière à constituer les bouchons 13 refermant les orifices 12 du second capot 10.

En fin de procédé, l'enrobage 11 en matière plastique peut être surmoulé, de manière connue, sur le second capot 10.

Le dépôt de la couche d'obturation peut être fait, par exemple, par dépôt chimique en phase vapeur ou par évaporation ou encore plus simplement par dépôt d'une couche en matériau polymère, par exemple une couche en résine. Il n'est pas forcément indispensable d'avoir une très bonne étanchéité de la seconde cavité 9, lorsqu'elle sera recouverte par l'enrobage 11 en matière plastique surmoulée. Il est ainsi suffisant d'assurer l'étanchéité de la seconde cavité 9 temporairement jusqu'à ce que l'enrobage 11 soit surmoulé sur le second capot 10, comme représenté à la figure 1. Le plastique de l'enrobage 11 ayant généralement une viscosité importante, il est même possible, dans certains cas, de ne pas boucher les orifices 12 du second capot 10, sans que le plastique n'entre dans les orifices 12. La pression hydrostatique est alors en partie transmise au premier capot 8, par les gaz contenu éventuellement dans la seconde cavité 9, mais les forces de cisaillement, exercées sur le premier capot d'un composant selon l'art antérieur, sont supprimées, ce qui peut suffir pour préserver l'intégrité du premier capot 8.

## Revendications

1. Composant (1) comportant des micro-systèmes électromécaniques (2) intégrés dans une première cavité (3) étanche délimitée au moins par un substrat (4, 6, 14) et par une paroi supérieure (7), constituée par au moins une partie (8a) d'un premier capot (8), le composant comportant un second capot (10), constitué par une couche mince, délimitant une seconde cavité, au moins avec la totalité de la paroi supérieure (7) de la première cavité (3), le second capot (10) étant en contact avec des parties inférieures (8b) du premier capot, lesdites parties inférieures reposant sur le substrat et disposées de part et d'autre d'une partie surélevée (8a) du premier capot ou avec le substrat (4, 6, 14).

2. Composant selon la revendication 1, **caractérisé en ce que** le second capot (10) comporte au moins un orifice (12).

3. Composant selon la revendication 2, **caractérisé en ce qu'**il comporte un bouchon (13) refermant l'orifice (12).

4. Composant selon l'une quelconque des revendications 1 à 3, **caractérisé en ce que** la couche mince constituant le second capot (10) est bombée.

5. Composant selon l'une quelconque des revendications 1 à 4, **caractérisé en ce que** le composant (1) comporte un enrobage (11).

6. Composant selon la revendication 5, **caractérisé en ce que** le second capot (10) est recouvert par l'enrobage (11).

7. Composant selon la revendication 6, **caractérisé en ce que** l'enrobage (11) est en matière plastique surmoulée.

8. Procédé de fabrication d'un composant (1) selon la revendication 1, comportant successivement, après la réalisation des micro-systèmes électromécaniques (2) et du premier capot (8) délimitant une première cavité (3) étanche,
- le dépôt, sur la totalité de la paroi supérieure (7) de la première cavité (3), d'une couche en matière polymère (18),
- le recuit de la couche en matière polymère (18),
- le dépôt, sur la couche en matière polymère (18), de la couche mince destinée à former le second capot (10),
- la gravure d'au moins un orifice (12) dans le second capot (10),
- l'enlèvement de la couche en matière polymère (18) par l'intermédiaire de l'orifice (12).

9. Procédé selon la revendication 8, **caractérisé en ce qu'**il comporte, après l'enlèvement de la couche en matière polymère (18), le dépôt d'une couche d'obturation constituant un bouchon (13) refermant l'orifice (12) du second capot (10).

10. Procédé selon la revendication 9, **caractérisé en ce que** la couche d'obturation de l'orifice (12) est constituée par une résine.

11. Procédé selon l'une quelconque des revendications 8 à 10, **caractérisé en ce qu'**il comporte, en fin de procédé, la réalisation d'un enrobage (11) en matière plastique surmoulée.

## Patentansprüche

1. Bauelement (1), das integrierte elektromechanische Mikrosysteme (2) in einem ersten dichten Hohlraum (3) aufnimmt, der mindestens durch ein Substrat (4, 6, 14) und durch eine obere Wand (7) abgegrenzt ist, welche von mindestens einem Teil (8a) eines ersten Deckels (8) gebildet wird, wobei das Bauelement einen zweiten Deckel (10) aufweist, der von einer dünnen Schicht gebildet wird, die mindestens mit der Gesamtheit der oberen Wand (7) des ersten Hohlraums (3) einen zweiten Hohlraum abgrenzt, wobei sich der zweite Deckel (10) mit unteren Teilen (8b) des ersten Deckels, welche unteren Teile auf dem Substrat sitzen und beiderseits eines erhöhten Teils (8a) des ersten Deckels angeordnet sind, oder mit dem Substrat (4, 6, 14) in Kontakt befindet.

2. Bauelement nach Anspruch 1,
**dadurch gekennzeichnet,**
**dass** der zweite Deckel (10) mindestens eine Öffnung (12) aufweist.

3. Bauelement nach Anspruch 2,
**dadurch gekennzeichnet,**
**dass** es einen Verschluss (13) aufweist, der die Öffnung (12) verschließt.

4. Bauelement nach einem der Ansprüche 1 bis 3,
**dadurch gekennzeichnet,**
**dass** die dünne Schicht, die den zweiten Deckel (10) bildet, gewölbt ist.

5. Bauelement nach einem der Ansprüche 1 bis 4,
**dadurch gekennzeichnet,**
**dass** das Bauelement (1) einen Mantel (11) aufweist.

6. Bauelement nach Anspruch 5,
**dadurch gekennzeichnet,**
**dass** der zweite Deckel (10) von dem Mantel (11) bedeckt ist.

7. Bauelement nach Anspruch 6,
**dadurch gekennzeichnet,**
**dass** der Mantel (11) aus konfektioniertem Kunststoff besteht.

8. Verfahren zur Herstellung eines Bauelements gemäß Anspruch 1, das nach der Herstellung der elektromechanischen Mikrosysteme (2) und des ersten Deckels (8), der einen ersten dichten Hohlraum (3) abgegrenzt, in den aufeinander folgenden Schritten besteht:
- Auftragen einer Schicht aus Polymer-Werkstoff (18) auf die gesamte obere Wand (7) des ersten Hohlraum (3),
- Nachhärten der Polymer-Schicht (18),
- Auftragen der dünnen Schicht, die dazu bestimmt ist, den zweiten Deckel (10) zu bilden, auf die Polymer-Schicht (18),
- Einschneiden von mindestens einer Öffnung (12) in den zweiten Deckel (10),
- Entfernen der Polymer-Schicht (18) durch die Öffnung (12).

9. Verfahren nach Anspruch 8,
**dadurch gekennzeichnet,**
**dass** es nach dem Entfernen der Polymer-Schicht (18) das Auftragen einer Abdichtungsschicht beinhaltet, die einen Verschluss (13) bildet, der die Öffnung (12) in dem zweiten Deckel (10) verschließt.

10. Verfahren nach Anspruch 9,
**dadurch gekennzeichnet,**
**dass** die Abdichtungsschicht auf der Öffnung (12) aus einem Harz besteht.

11. Verfahren nach einem der Ansprüche 8 bis 10,
**dadurch gekennzeichnet,**
**dass** es zum Schluss die Herstellung eines Mantels (11) aus konfektioniertem Kunststoff beinhaltet.

## Claims

1. Component (1) comprising micro electromechanical systems (2) integrated in a first airtight cavity (3) bounded at least by a substrate (4, 6, 14) and by a top wall (7), formed by at least a part (8a) of a first cover (8), the component comprising a second cover (10), formed by a thin layer, bounding a second cavity (9), at least with the whole of the top wall (7) of the first cavity (3), the second cover (10) being in contact with lower parts (8b) of the first cover, said lower parts sitting on the substrate and disposed on both side of a top part (8a) of the first cover.

2. Component according to claim 1, **characterized in that** the second cover (10) comprises at least one orifice (12).

3. Component according to claim 2, **characterized in that** it comprises a plug (13) closing off the orifice (12).

4. Component according to any one of the claims 1 to 3, **characterized in that** the thin layer forming the second cover (10) is convex.

5. Component according to any one of the claims 1 to 4, **characterized in that** the component (1) comprises a coating (11).

6. Component according to claim 5, **characterized in that** the second cover (10) is covered by the coating (11).

7. Component according to claim 6, **characterized in that** the coating (11) is made of plastic material molded from a casting.

8. Fabrication process of a component (1) according to claim 1, comprising successively , after the micro electromechanical systems (2) and the first cover (8) defining an airtight cavity have been achieved:
- deposition of a layer of polymer material (18) on the whole of the top wall (7) of the first cavity (3),
- annealing of the layer of polymer material (18),
- deposition of the thin layer designed to form the second cover (10) on the layer of polymer material (18),
- etching of at least one orifice (12) in the second cover (10),
- removal of the layer of polymer material (18) by means of the orifice (12).

9. Process according to claim 8, **characterized in that** it comprises deposition of a sealing layer forming a plug (13) closing off the orifice (12) of the second cover (10), after the layer of polymer material (18) has been removed.

10. Process according to claim 9, **characterized in that** the sealing layer of the orifice (12) is constituted by a resin.

11. Process according to any one of the claims 8 to 10, **characterized in that** it comprises fabrication of a coating (11) of plastic material molded from a casting at the end of the process.
